(19) Europäisches Patentamt
European Patent Office
Office européen des brevets

(11) EP 0 907 106 A1

(12) # EUROPEAN PATENT APPLICATION

published in accordance with Art. 158(3) EPC

(43) Date of publication:
**07.04.1999 Bulletin 1999/14**

(21) Application number: **98901508.6**

(22) Date of filing: **04.02.1998**

(51) Int. Cl.[6]: **G03F 1/14**, H01L 21/027

(86) International application number:
**PCT/JP98/00465**

(87) International publication number:
**WO 98/36324 (20.08.1998 Gazette 1998/33)**

(84) Designated Contracting States:
**CH DE FR GB IT LI NL**

(30) Priority: **13.02.1997 JP 29072/97**
**13.02.1997 JP 29074/97**
**13.02.1997 JP 29075/97**

(71) Applicant:
**Mitsui Chemicals, Inc.**
**Tokyo 100-6070 (JP)**

(72) Inventors:
- **SHIGEMATSU, Shigeto,**
**Mitsui Chemicals, Inc.**
**Kuga-gun Yamaguchi 740-0061 (JP)**
- **NAKAGAWA, Hiroaki,**
**Mitsui Chemicals, Inc.**
**Kuga-gun Yamaguchi 740-0061 (JP)**

(74) Representative: **HOFFMANN - EITLE**
**Patent- und Rechtsanwälte**
**Arabellastrasse 4**
**81925 München (DE)**

(54) **PELLICLE MEMBRANE FOR ULTRAVIOLET RAYS AND PELLICLE**

(57) The present invention provides a pellicle and a pellicle film material having an excellent transmittance for ultraviolet with a wavelength of up to 200 nm and being excellent in light resistance (durability) and film strength.

The pellicle film of the present invention comprises an organic polymer which, when formed into a film with a thickness of d μm, exhibits an average light absorptance of A % at wave range of exposure light source, the thickness d and the average light absorptance A satisfying the relationship: $A/d \leq 1.0$ (%/μm). The pellicle film is one for ultraviolet having a wavelength of 140 to 200 nm.

It is preferred that the pellicle film have a thickness of 0.1 to 10 μm.

In the present invention, for example, a silicone polymer whose main chain is composed of siloxane bond (Si-O bond) can be mentioned as a pellicle film material. The silicone polymer preferably has a fluorine (F) containing group as a branch chain group.

Further, a fluororesin consisting of carbon (C) and fluorine (F) as constituent elements is preferably used as a pellicle film material.

The pellicle of the present invention comprises the above pellicle film.

*Fig. 4*

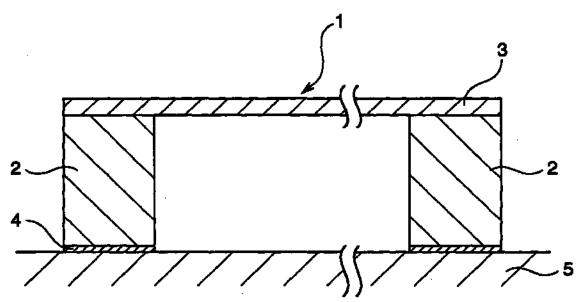


EP 0 907 106 A1

## Description

FIELD OF INVENTION

The present invention relates to a pellicle film suitably employed especially when an ultraviolet having a wavelength as small as 140 to 200 nm is used as an exposure light source and relates to a pellicle using the same.

BACKGROUND ART

In the semiconductor process, when highly integrated circuits (LSIs) are made according to photolithography, the mask substrate commonly has its one side or both sides fitted with a pellicle (light transmissive dust protector) in order to avoid sticking of foreign matter such as dust onto a photomask (or including reticle) and transfer thereof onto the wafer.

This pellicle is generally so constructed that a pellicle film (light transmissive dust protecting film) is held with an appropriate spacing from the surface of the mask substrate by means of a holding frame of, for example, aluminum. Thus, in the transfer of the wiring pattern on the mask substrate surface onto the wafer, the surfaces of the mash substrate and the pellicle film are different in image forming focal length from each other, so that, even if foreign matter is sticking to the pellicle surface, the foreign matter is not transferred onto the wafer.

Therefore, covering the mask with the pellicle enables preventing the contamination of foreign matter from outside with the result that not only the production efficiency of photolithography but also the yield of the production of semiconductor elements can be enhanced.

The above pellicle film is required to have satisfactory film strength, durability and light transmittance, especially, light transmittance at exposure wavelength. Cellulose materials such as nitrocellulose and cellulose propionate are commonly employed as the material of pellicle film for light such as g-ray (436 nm) and i-ray (365 nm).

In recent years, in the semiconductor process, there is a tendency to reduce the wavelength of exposure light source so that the degree of integration is increased in accordance with the pattern fining. For example, the writing with the use of KrF excimer laser ($\lambda$ = 248 nm) as exposure light source is now being realized. Moreover, the application of ultraviolet having a wavelength ($\lambda$) as small as $\leq$ 200 nm is being studied, and, especially, the employment of ArF excimer laser ($\lambda$= 193 nm) is most likely.

However, the transmittance of conventional cellulose materials is not satisfactory for light of a short wave range of up to 300 nm.

Furthermore, the smaller the wavelength of laser radiation, the greater the photon energy thereof. For example, the energy of ArF excimer laser is 6.4 eV (147 kcal/mol), which is greater than the dissociation energy of C-H bond (98.8 kcal/mol) and dissociation energy of C-C bond (83.6 kcal/mol) of organic polymer. When KrF excimer laser or ArF excimer laser is used as the exposure light source, the pellicle film material composed of conventional organic polymer such as cellulose material readily suffers from photodecomposition (photodegradation) upon being irradiated with the laser with the result that the pellicle cannot stand practical use.

Therefore, novel pellicle film materials for short wave laser are now demanded. For example, the use of a fluororesin as a pellicle film material has been proposed. In particular, it has been proposed to employ fluororesins whose main chain has a ring structure and contains C-O bonds, such as commercially available Cytop (trade name) and Teflon AF (trade name) represented by the following formulae (see, for example, Japanese Patent Laid-open Publication No. 3(1991-39963):

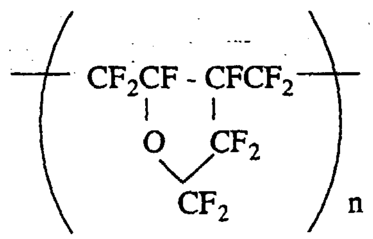

Cytop (trade name),

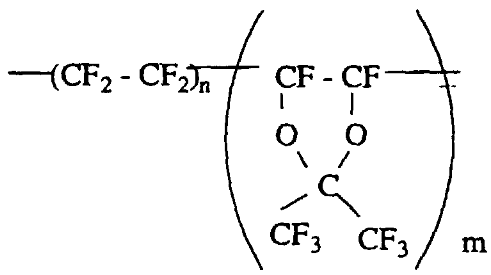

Teflon AF (trade name).

The above fluororesins exhibit desirable transmittance at not only a long wave range of at least 300 nm but also a short wave range of up to 300 nm. However, the inventor's studies showed that, in the use of ArF excimer laser, the light resistance (durability) of the above fluororesins is not satisfactory because of the inclusion, in the main chain ring structure, of C-O bonds whose dissociation energy is smaller than that of C-F bonds.

Therefore, there is a demand for the development of, especially, a pellicle film material and a pellicle which are excellent in not only the transmittance for ultraviolet with a wavelength of up to 200 nm but also the light resistance (durability) and film strength and which can be utilized even when, four example, ArF excimer laser is used as the exposure light source.

DISCLOSURE OF THE INVENTION

The pellicle film of the present invention comprises an organic polymer which, when formed into a film with a thickness of d μm, exhibits an average light absorptance of A % at wave range of exposure light source, said thickness d and average light absorptance A satisfying the relationship: $A/d \leq 1.0$ (%/μm), and said pellicle film being one for ultraviolet having a wavelength of 140 to 200 nm.

The exposure light source may exhibit a wavelength ranging from 140 to 200 nm.

The pellicle film preferably has a thickness of 0.1 to 10 μm.

In the present invention, the material of the pellicle film may be made of a silicone polymer whose principal chain is composed of siloxane bond (Si-O bond). This silicone polymer preferably has a fluorine (F) containing group as a branch chain group.

Further, in the present invention, a fluororesin consisting of carbon (C) and fluorine (F) ash constituent elements can be mentioned as a material of the pellicle film. For example, this fluororesin can have a structure represented by the following formula:

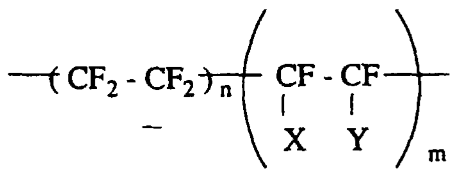

wherein n and m satisfy the relationship:

$$(0.05 \le \frac{m}{n+m} \le 1, \text{ each of X and Y represents F or } CF_3).$$

It is preferred that this fluororesin be a tetrafluoroethylene/hexafluoropropylene copolymer represented by the following formula:

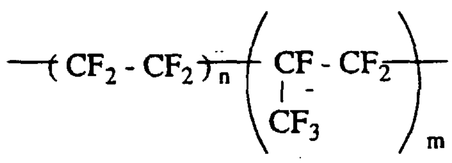

wherein n and m satisfy the relationship:

$$0.05 \le \frac{m}{n+m} \le 1.$$

The pellicle of the present invention comprises the above pellicle film.

BRIEF DESCRIPTION OF THE DRAWING

Fig. 1 shows an up to 200 nm light absorption spectrum of polytetrafluoroethylene computed by the molecular orbital method (simulation);
Fig. 2 shows a light absorption spectrum of silicone polymer for use in the present invention, computed by the molecular orbital method (simulation);
Fig. 3 shows a light absorption spectrum of silicone polymer for use in the present invention, computed by the molecular orbital method (simulation); and
Fig. 4 shows one form of pellicle according to the present invention.

BEST MODE FOR CARRYING OUT THE INVENTION

The pellicle film and pellicle of the present invention will be described in detail below.
The pellicle film of the present invention is employed when an ultraviolet having a wavelength of 140 to 200 nm is used as the exposure light source and comprises the following organic polymer.
The organic polymer used as a film material in the present invention is one which, when formed into a film with a thickness of d $\mu$m, exhibits an average light absorptance of A % at wave range of exposure light source, said thickness d and average light absorptance A satisfying the following relationship:

$$A/d \le 1.0 \ (\%/\mu m).$$

The ratio A/d means the average light absorptance per thickness of the organic polymer.
The above average light absorptance A (%) is determined by calculating the light absorptance $A_\lambda$ at a wave-

length of $\lambda$ according to the following formula:

$$A_\lambda = 100 - (T_\lambda + R_\lambda)\ (\%)$$

wherein $T_\lambda$ represents the light transmittance at a wavelength of $\lambda$ and $R_\lambda$ represents the light reflectance at a wavelength of $\lambda$, and by averaging the light absorptance $A_\lambda$ over the wave range of exposure light source.

It is preferred that the organic polymer for use in the present invention be amorphous.

The tensile strength of the organic polymer is preferably at least about 100 $kg/cm^2$, and the bending strength thereof is preferably at least about 200 $kg/cm^2$. When the pellicle film is prepared from the organic polymer of the above strength, the realized film strength can be satisfactory, enabling repeated use of the film.

Although organic polymers satisfying the above characteristics and capable of realizing the satisfactory film strength can be used without any particular limitation as the film materials in the present invention, organic polymers exhibiting high transmittance at a wave range of 140 to 200 nm and having a molecular structure wherein the interatomic bonding energy is high can be mentioned as examples of film materials.

Examples of these organic polymers include polymers whose principal chain is composed of, for example, C-F bonds, C-C bonds or Si-O bonds and whose branch chain group is composed of, for example, an alkyl group such as methyl, fluorine, a fluorinated alkyl group, a cycloalkyl group or a fluorinated cycloalkyl group. Specific examples of such polymers will be described in detail later.

The light transmittance at wave range $\lambda$ = 140 to 200 nm of each organic polymer can be calculated by the molecular orbital method. Specifically, the light absorption spectrum resulting from electron excitation (simulation) can be presumed by calculating the electron energy level of the polymer by the molecular orbital method and determining the energy gap between HOMO (highest occupied molecular orbital) and LUMO (lowest unoccupied molecular orbital).

From the above presumption of the light transmittance at a wave range of up to 200 nm of, for example, polytetrafluoroethylene $(-CF_2CF_2-)_n$, it is found that the polymer does not exhibit any absorption at wave range $\lambda$= 124 to 200 nm. This is shown in Fig. 1.

The pellicle film of the present invention is composed of the organic polymer satisfying the above characteristics and is excellent in the 140 to 200 nm ultraviolet transmittance and, for example, it is preferred that the average light absorptance at wave range of exposure light source exhibited when the thickness of the pellicle film is 1 μm be up to 1.0%, especially, up to 0. 5%.

Further, it is preferred that this pellicle film be also excellent in transmittane of light having a wave length of from the short wave ultraviolet region at least 200 nm to the visible region. Although the thickness of the pellicle film is not particularly limited as long as the pellicle film has a required strength and the aberration at the time of exposure is slight and as long as the average light absorptance A and thickness d satisfy the above relationship, it is generally preferred that the film thickness range from 0.1 to 10 μm, especially, from 0.3 to 5 μm. The film thickness can be selected from among the values of the above range by calculating a thickness such that the transmittance for exposure wavelength is high by the following formula:

$$d = \frac{m\lambda}{2n}$$

wherein m is an integer of 1 or greater,

d represents the thickness of pellicle film (when the film is composed of a single layer),
n represents the refractive index of polymer, and
$\lambda$ represents the exposure wavelength (e.g., 193 nm in the use of ArF excimer laser).

The above pellicle film of the present invention exhibits a high transmittance for ultraviolet with a wavelength of 140 to 200 nm and scarcely absorbs ultraviolet, so that the possibility of undergoing photodecomposition is low irrespective of a long-time light irradiation, thereby ensuring excellent light resistance of the pellicle film.

The pellicle film described above can suitably be used when use is made of a light source capable of generating ultraviolet with a wavelength of 140 to 200 nm such as ArF excimer laser ( $\lambda$ = 193 nm) or $F_2$ laser ( $\lambda$ = 157 nm), especially, ArF excimer laser.

The pellicle film of the present invention may have its surface provided with an antireflection coating according to necessity.

Examples of the organic polymers for use as the pellicle film constituting material in the present invention include polysiloxanes (silicone polymers), fluororesins and fluorosilicone polymers. These organic polymers may have, for example, a linear structure, a branched structure, a ring structure, or a crosslinked structure.

Specifically, use can be made of silicone polymers whose main chain is composed of siloxane bonds (Si-O bonds).

The structure of the silicone polymer for use in the present invention is not particularly limited as long as the main chain is composed of siloxane bonds (Si-O bonds). For example, the silicone polymer may have a linear structure, a branched structure, a ring structure, or a crosslinked structure.

In this silicone polymer, the branch chain group bonded to the main chain (Si-O bonds) may be an alkyl group such as methyl, ethyl or cyclohexyl ($C_6H_{11}$), or a fluorine containing group such as $-CF_3$, $-C_6F_{11}$ or -F, or a combination thereof.

The repeating unit of the silicone polymer is, for example, represented by the following formulae:

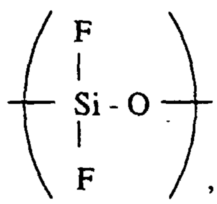

,

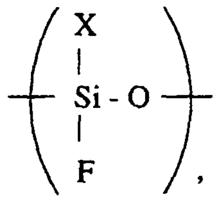

,

(X: fluorocarbon group such as $CF_3$ or $C_6F_{11}$ or alkyl such as $CH_3$ or $C_6H_{11}$),

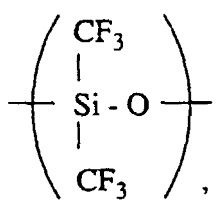

, and

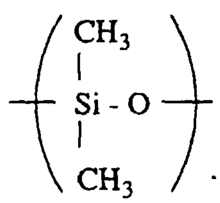

.

The silicone polymer for use in the present invention may be a homopolymer whose repeating unit is any one selected from among the above repeating units or a copolymer composed of a plurality of repeating units selected from among the above repeating units.

It is preferred that the silicone polymer be amorphous.

The pellicle film composed of the above silicone polymer is excellent in transmittance of the light having a wave length of from visible region to short wave ultraviolet region. Especially, the pellicle film exhibits a high transmittance for ultraviolet with a wavelength of 140 to 200 nm and scarcely absorbs ultraviolet, so that the pellicle film is free from photodecomposition irrespective of a long-time light irradiation, with the high light transmittance retained.

With respect to the light transmittance of the silicone polymer, the light absorption spectrum computed by the above molecular orbital method (simulation) is shown in Fig. 2. That is, with respect to the silicone polymer represented by the below given formula (dimethylpolysiloxane), the light absorption spectrum resulting from electron excitation was presumed by calculating the electron energy level of the polymer by the molecular orbital method and determining the energy gap between HOMO (highest occupied molecular orbital) and LUMO (lowest unoccupied molecular orbital):

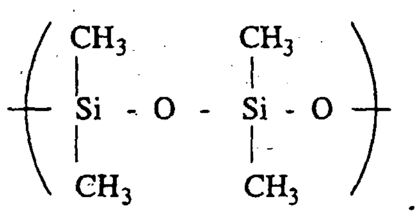

The light absorption spectrum obtained in the above manner (simulation) is shown in Fig. 3 with respect to the silicone polymer represented by the formula:

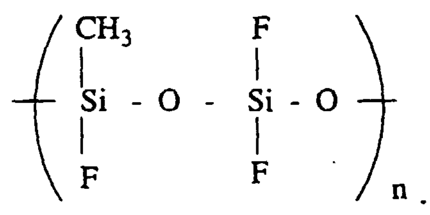

As apparent from Figs. 2 and 3, the silicone polymer for use in the present invention does not absorb light of wavelength $\lambda$ = 140 to 200 nm. Therefore, the pellicle film composed of this silicone polymer can suitably be used when use is made of an exposure light source of ArF excimer laser ($\lambda$ = 193 nm).

Further, in the present invention, fluororesins consisting of carbon (C) and fluorine (F) only as constituent elements can also suitably be used as a pellicle film constituting material.

The structure of the fluororesin for use in the present invention is not particularly limited as long as the fluororesin consists of carbon and fluorine only as constituent elements. For example, the fluororesin may have a linear structure composed of $-CF_2$ units, a branched structure, a crosslinked structure, or a ring structure.

In the present invention, preferred use is made of the fluororesin with the structure of the formula:

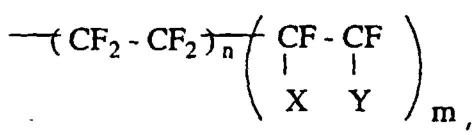

wherein

$$0.05 \leq \frac{m}{n+m} \leq 1$$

In the above repeating units, each of X and Y independently represents F or $CF_3$.

Among these fluororesins, it is preferred that X and Y represent $CF_3$ and F, respectively. Specifically, preferred use is made of a tetrafluoroethylene/hexafluoropropylene copolymer (FEP) represented by the formula:

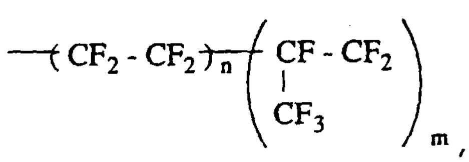

wherein

$$0.05 \leq \frac{m}{n+m} \leq 1$$

The above tetrafluoroethylene/hexafluoropropylene copolymer can be produced by the customary procedure. Still further, for example, use can be made of polytetrafluoroethylene (PTFE).

It is preferred that the above fluororesin be amorphous.

The pellicle film composed of the above fluororesin is excellent in the transmittance of the light having a wave length of from visible region to short wave ultraviolet region. Especially, the pellicle film exhibits a high transmittance for ultraviolet with a wavelength of 140 to 200 nm and scarcely absorbs ultraviolet, so that the pellicle film is free from photodecomposition irrespective of a long-time light irradiation, with the high light transmittance retained.

With respect to the light transmittance of the fluororesin consisting of carbon and fluorine only as constituent elements, the light absorption spectrum computed by the above molecular orbital method (simulation) is shown in Fig. 1. That is, with respect to the fluororesin (PTFE) of $-CF_2$ repeating units only, the light absorption spectrum resulting from electron excitation was presumed by calculating the electron energy level of the polymer by the molecular orbital method and determining the energy gap between HOMO (highest occupied molecular orbital) and LUMO (lowest unoccupied molecular orbital).

As apparent from Fig. 1, the fluororesin of the above molecular structure absorbs only light with a wavelength of smaller than 123 nm and scarcely absorbs light with a wavelength of 140 to 200 nm.

The pellicle film composed of the above fluororesin is employed when use is made of an exposure light source of ultraviolet with a wavelength of 140 to 200 nm. Especially, the pellicle film scarcely absorbs ultraviolet with wavelength $\lambda$= 140 to 200 nm as mentioned above and, hence, can suitably be employed when use is made of an exposure light source of ArF excimer laser ($\lambda$ = 193 nm).

In the present invention, in the production of the above pellicle film, the organic polymer can be formed into a film by, for example, the rotary film forming method in which a polymer solution or suspension is applied onto a clean smooth substrate and a spinner is rotated, the immersion method in which a substrate of, for example, glass having a clean smooth surface is immersed in a polymer solution or suspension and lifted up to thereby form a thin film, the vapor deposition method, the polymer machining, or the fusion molding method.

As the above substrate, use can be made of, for example, an inorganic single crystal substrate such as a silicon wafer or a sapphire wafer; a substrate of a metal such as aluminum or nickel; a substrate of a ceramic such as aluminum oxide, magnesium oxide, quartz glass or soda lime glass; a substrate of an organic material such as polycarbonate or an acrylic resin; a substrate comprising the above inorganic single crystal substrate, metal substrate, ceramic substrate or organic material substrate and, superimposed thereon by, for example, the CVD method or the spin coating method, a thin metal film, a thin ceramic film or a thin organic material film; or a metal film such as aluminum foil or an organic material film such as nitrocellulose film extended on a frame of, for example, a metal.

The thus obtained thin film is dried by, for example, hot air or infrared irradiation and, when the suspension is used, further sintered at higher temperature. Thereafter, the thin film is stripped from the substrate, thereby obtaining the pellicle film (single layer film).

The stripping of the thin film from the substrate can be accomplished by various methods including the immersion of the substrate in water, the physical peeling, the etching of the substrate by the use of, for example, an etching solution, the dissolution of the substrate in, for example, a solvent or the decomposition of the substrate by heating. When the substrate is immersed in water, the application of ultrasonic vibration or the use of hot water facilitates the stripping.

Moreover, in the present invention, the thin film (pellicle film) can be formed by the method, other than the above methods of preparing the pellicle film with the use of the substrate, in which a polymer solution is spread on the surface of a liquid having a specific gravity and a surface tension which are greater than those of the polymer solution and is, as it is, formed into a thin film (pellicle film). When the organic polymer is a fluororesin, for example, acetylene tetrabromide ($CHBr_2CHBr_2$) can be used as such a liquid.

The pellicle of the present invention comprises the above pellicle film as an essential constituent, and the other constituents are not particularly limited. For example, referring to Fig. 4, pellicle 1 consists of pellicle film 3, holding frame 2 and adhesive 4. The pellicle film 3 is extended on the holding frame 2, and the holding frame 2 is held on mask substrate 5 by means of the adhesive 4 or the like. Thus, the pellicle 1 can be held on the mask substrate 5.

EFFECT OF THE INVENTION

The pellicle film of the present invention exhibits excellent light transmittance and light resistance when use is

made of an exposure light source of 140 to 200 nm ultraviolet. Further, the film strength is excellent, so that the pellicle film can be suitably used as, for example, a pellicle film for ArF excimer laser.

EXAMPLE

The present invention will be further illustrated below with reference to the following Example, which in no way limits the scope of the invention.

Example 1

Light resistance test was performed by irradiating a 25 μm thick FEP (tetrafluoroethylene/hexafluoropropylene copolymer) film with ArF excimer laser under the following conditions:

| | |
|---|---|
| exposure | : $1 \times 10^4$ J/$cm^2$, |
| pulse energy density | : 80 mJ/$cm^2$P, |
| frequency | : 40 Hz, |
| atmosphere | : nitrogen, and |
| irradiated area | : 10 mm x 5 mm. |

After the irradiation, the vicinity of irradiated part was observed through a laser microscope and the measurement of any level difference attributed to film decrease caused by the laser irradiation was conducted. There was no appearance change attributed to the laser irradiation, and no film decrease was observed.

Comparative Example 1

Light resistance test was performed by carrying out the laser irradiation in the same manner as in Example 1, except that the FEP as a film material was replaced by fluororesin Cytop (trade name, produced by Asahi Glass Co., Ltd.) of the formula:

CYTOP (trade name):

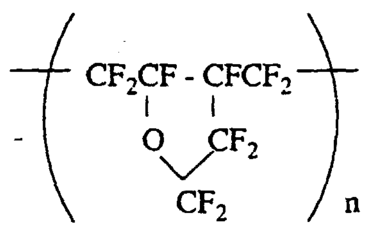

In this film, micron or submicron sized pin holes were observed at the laser irradiated part. Further, a film decrease occurred and the reduction of the film thickness by about 0.1 to 0.2 μm was observed.

**Claims**

1. A pellicle film for ultraviolet having a wavelength of 140 to 200 nm, comprising an organic polymer which, when formed into a film with a thickness of d μm, exhibits an average light absorptance of A % at wave range of exposure light source, said thickness d and said average light absorptance A satisfying the relationship:

$$A/d \leq 1.0\ (\%/\mu m).$$

2. The pellicle film as claimed in claim 1, wherein the exposure light source exhibits a wavelength ranging from 140 to 200 nm.

3. The pellicle film as claimed in claim 1 or 2, which has a thickness of 0.1 to 10 μm.

4. A pellicle film for ultraviolet comprising a silicone polymer whose main chain is composed of siloxane bond (Si-O bond).

5. The pellicle film as claimed in claim 4, wherein the silicone polymer has a fluorine (F) containing group as a branch chain group.

6. The pellicle film as claimed in any of claims 1 to 3, wherein the organic polymer is composed of a fluororesin consisting of carbon (C) and fluorine (F) as constituent elements.

7. The pellicle film as claimed in claim 6, wherein the fluororesin is represented by the following formula:

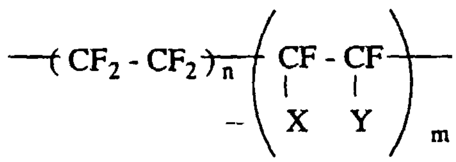
,

wherein n and m satisfy the following relationship:

$$0.05 \le \frac{m}{n+m} \le 1,$$

wherein each of X and Y represents F or $CF_3$.

8. The pellicle film as claimed in claim 7, wherein the fluororesin is a tetrafluoroethylene/hexafluoropropylene copolymer represented by the formula:

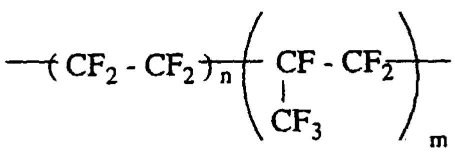
,

wherein n and m satisfy the relationship:

$$0.05 \le \frac{m}{n+m} \le 1,$$

9. A pellicle comprising the pellicle film of any of claims 1 to 8.

Fig. 1

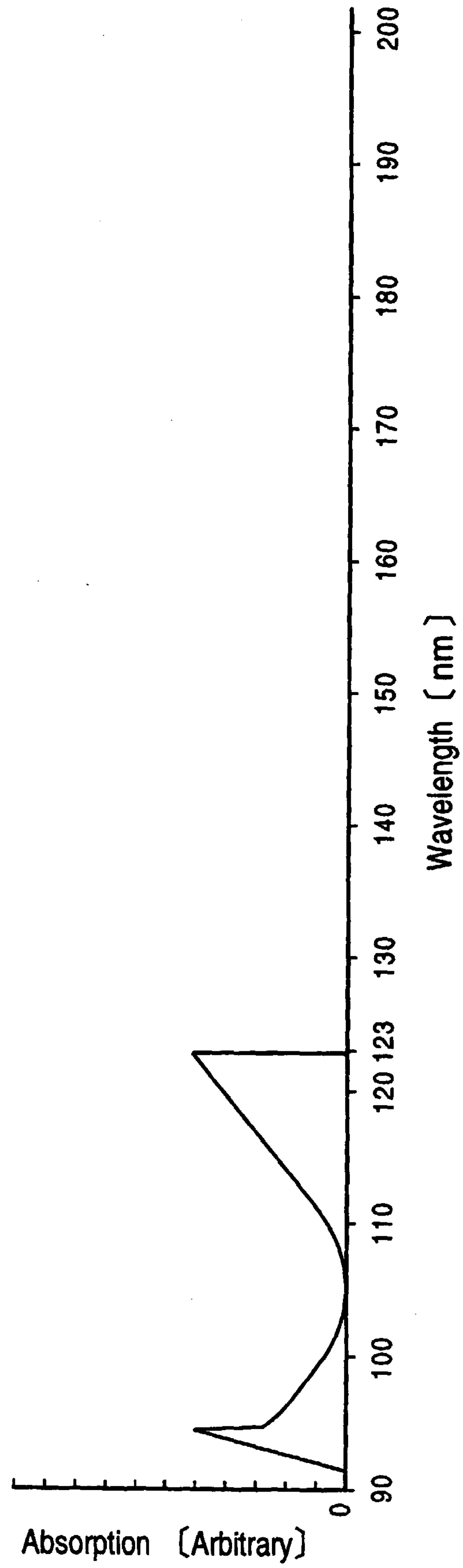

Absorption (Arbitrary)
0
Wavelength (nm)
90
100
110
120
123
130
140
150
160
170
180
190
200

Fig. 2

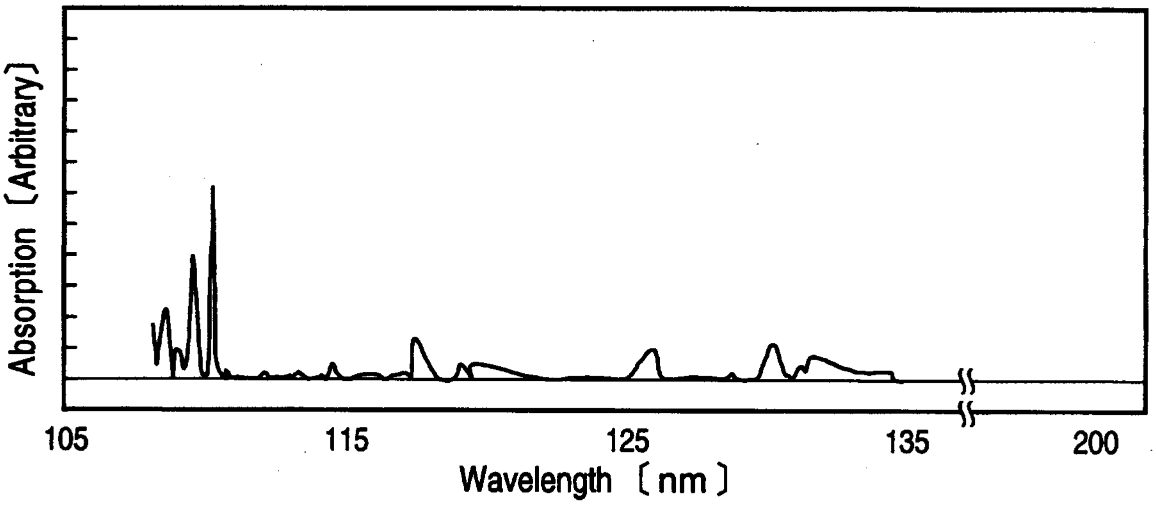
Absorption [Arbitrary]
105
115
125
135
200
Wavelength [nm]

Fig. 3

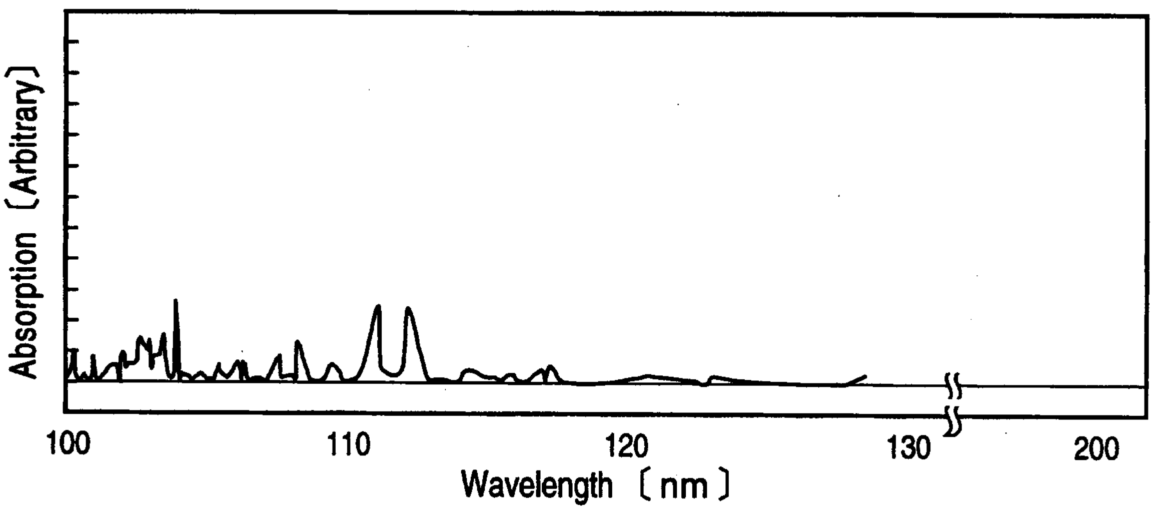
Absorption [Arbitrary]
100
110
120
130
200
Wavelength [nm]

*Fig. 4*

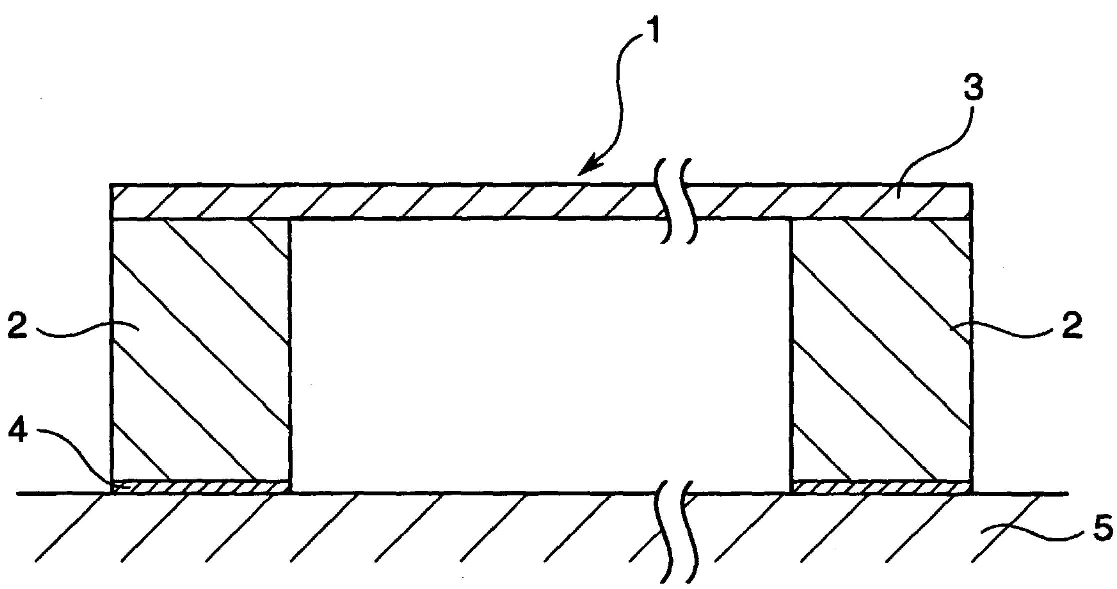

## INTERNATIONAL SEARCH REPORT

International application No.
PCT/JP98/00465

A. CLASSIFICATION OF SUBJECT MATTER
Int.Cl⁶ G03F1/14, H01L21/027

According to International Patent Classification (IPC) or to both national classification and IPC

B. FIELDS SEARCHED

Minimum documentation searched (classification system followed by classification symbols)
Int.Cl⁶ G03F1/14, H01L21/027

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-1998 |
| Kokai Jitsuyo Shinan Koho | 1971-1998 | Jitsuyo Shinan Toroku Koho | 1996-1998 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>X | JP, 1-241557, A (Bando Chemical Industries Ltd.), September 26, 1989 (26. 09. 89), Page 2, lower left column, line 12 to lower right column, line 15 (Family: none) | 1-3<br>6-9 |
| X | JP, 5-216213, A (Shin-Etsu Chemical Co., Ltd.), August 27, 1993 (27. 08. 93), Claim 2, chemical formula 1, Rf & EP, 554150, A & US, 5370951, A | 4, 5, 9 |
| X<br>Y | JP, 5-88359, A (Shin-Etsu Chemical Co., Ltd.), April 9, 1993 (09. 04. 93), Claim 1, chemical formula 1 & US, 5691088, A | 4, 9<br>5 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>April 28, 1998 (28. 04. 98) | Date of mailing of the international search report<br>May 12, 1998 (12. 05. 98) |
| Name and mailing address of the ISA/<br>Japanese Patent Office | Authorized officer |
| Facsimile No. | Telephone No. |

Form PCT/ISA/210 (second sheet) (July 1992)